# EUROPÄISCHE PATENTSCHRIFT

(11) **EP 2 819 494 B1**
(45) Veröffentlichungstag und Bekanntmachung des Hinweises auf die Patenterteilung: **16.05.2018**
(21) Anmeldenummer: 13174037.5
(22) Anmeldetag: 27.06.2013
(51) Int. Cl.: H05K 7/14, H05K 5/00

(54) **Modulares Kommunikationsgerät für ein industrielles Automatisierungssystem**
Modular communication device for an industrial automation system
Appareil de communication modulaire pour un système d'automatisation industriel

(43) Veröffentlichungstag der Anmeldung: 31.12.2014
(73) Patentinhaber: Siemens Aktiengesellschaft, 80333 München (DE)
(72) Erfinder: Schweizer, Urs, 76316 Malsch-Waldprechtsweier (DE)

(56) Entgegenhaltungen:
- WO-A1-02/23676
- DE-A1-102004 056 832
- DE-A1-102007 004 865
- US-A- 4 790 762
- US-A1- 2009 141 458

## Beschreibung

Die vorliegende Erfindung betrifft ein modulares Kommunikationsgerät für ein industrielles Automatisierungssystem, wobei das modulare Kommunikationsgerät ein Grundmodul und zumindest ein mit dem Grundmodul verbindbares Erweiterungsmodul umfaßt.

Ein industrielles Automatisierungssystem umfaßt üblicherweise eine Vielzahl von industriellen Automatisierungsgeräten, die über ein industrielles Kommunikationsnetz miteinander vernetzt sind und im Rahmen einer Fertigungs- oder Prozeßautomatisierung zur Steuerung oder Regelung von Anlagen, Maschinen bzw. Geräten dienen. Aufgrund zeitkritischer Rahmenbedingungen in technischen Systemen, die mittels industrieller Automatisierungsgeräte automatisiert sind, werden in industriellen Kommunikationsnetzen zur Kommunikation zwischen Automatisierungsgeräten überwiegend Echzeit-Kommunikationsprotokolle, wie Profinet, Profibus oder Real-Time-Ethernet, verwendet.

Aus DE 10 2010 062065 A1 ist ein modulares Elektronikgerät bekannt, das ein elektronisches Grundgerät, ein Elektronikmodul zur elektrischen Verbindung mit dem Grundgerät und zur mechanischen Halterung am Grundgerät umfaßt. Das Elektronikmodul und das Grundgerät sind derart ausgestaltet, daß das Elektronikmodul in einer Anbringstellung mechanisch mit dem Grundgerät gekoppelt werden kann. Durch eine nachfolgende Schwenkbewegung kann das Elektronikmodul in eine Zwischenstellung geschwenkt und anschließend durch eine Schubbewegung in eine Verbindungsstellung gebracht werden. In der Verbindungsstellung ist das Elektronikmodul elektrisch mit dem Grundgerät verbunden und mechanisch an diesem fixiert.

In EP 1 901 598 B1 ist ein modulares Automatisierungsgerät mit einer Rückwand-Trägereinheit zum Einhängen von Steuerungsmodulen beschrieben, bei dem die Rückwand-Trägereinheit eine Kette von U-Steckern zur elektrischen Verbindung der Steuerungsmodule umfaßt. Zum Anbringen werden die Steuerungsmodule an einem Rückwand-Träger eingehängt und auf diesen aufgeschwenkt. Über die U-Stecker wird eine elektrische Verbindung zu benachbarten Steuerungsmodulen aufgebaut, die auf diese Weise einen Rückwandbus bilden.

Ein modularer Schalt-Netzknoten für ein industrielles Kommunikationsnetz ist aus EP 2 456 133 A1 bekannt. Der modulare Schalt-Netzknoten umfaßt eine Schalt-Netzknoten-Basiseinheit und mindestens ein Port-Modul, das mindestens eine Anschluss-Schnittstelle zur Ankopplung an das Kommunikationsnetz aufweist. Des weiteren ist der modulare Schalt-Netzknoten zur Weiterleitung von Kommunikationsdaten, die über eine Anschluss-Schnittstellen des modularen Schalt-Netzknotens eingehen, an mindestens eine weitere Anschluss-Schnittstelle ausgestaltet. Darüber hinaus kann zur Funktionalitätserweiterung ein Port-Modul gegen ein Funktionsmodul ausgetauscht werden.

Aus DE 692 00 539 T2 ist eine modulare elektronische Einheit bekannt, bei der ein elektronisches Modul mit einer Gehäusekante zunächst an einen Anschlag eines Modulträgers sowie an einem korrespondierenden Gehäuseanschlag am elektronischen Modul gekoppelt wird. Durch eine nachfolgende Schwenkbewegung wird das elektronische Modul gegen eine im Bereich des Anschlags angeordnete Klemmfeder in eine Verbindungsstellung gebracht, in der elektronisches Modul und Modulträger vorzugsweise miteinander verrastet sind.

US 2004/0184243 A1 betrifft eine Aufnahme von steckbaren Erweiterungskarten in einen Computer, bei dem eine Trägereinheit mit einer Anschlußplatine für steckbare Erweiterungskarte aus einem Gehäuse des Computers herausziehbar und um eine Querachse zur einfacheren Aufnahme von Erweiterungskarten schwenkbar ist. Dabei bildet die Trägereinheit einen festen Gehäusebestandteil, der zur Aufnahme von Erweiterungskarten vorgesehen ist. Eine erste Steckverbindung ist zwischen Erweiterungskarte und Anschlußplatine vorgesehen, während eine zweite Steckverbindung zwischen der Anschlußplatine und einer feststehenden Anschlußbaugruppe im Computer vorgesehen ist.

Das Dokument US2009/0141458 offenbart ein modulares Kommunikationsgerät gemäß dem Oberbegriff des Anspruchs 1. Der vorliegenden Erfindung liegt die Aufgabe zugrunde, ein modulares Kommunikationsgerät zu schaffen, das durch Erweiterungsmodule einfach und sicher erweitert kann, ohne daß die Erweiterungsmodule durch ihr Eigengewicht Steckverbindungen zwischen Gerätemodulen funktionell beeinträchtigen.

Diese Aufgabe wird erfindungsgemäß durch ein modulares Kommunikationsgerät mit den in Anspruch 1 angegebenen Merkmalen gelöst. Vorteilhafte Weiterbildungen der vorliegenden Erfindung sind in den abhängigen Ansprüchen angegeben.

Das erfindungsgemäße modulare Kommunikationsgerät umfaßt ein Grundmodul und zumindest ein mit dem Grundmodul verbindbares Erweiterungsmodul. Dabei weisen das Grundmodul und das zumindest eine Erweiterungsmodul zueinander korrespondierende mehrpolige Steckverbindungselemente auf. Am Erweiterungsmodul sind Zentrierstifte vorgesehen, die jeweils in eine Aussparung an einer Verrieglungskulisse des Grundmoduls einführbar und dort verrastbar sind. Die Zentrierstifte weisen jeweils eine sich an einen konischen Kopf anschließende umlaufende Nut auf, in die jeweils ein Rastelement der Verriegelungskulisse in einem verriegelten Zustand eingreift. Die Verriegelungskulisse ist senkrecht zu den Zentrierstiften von einer Verriegelungsposition in eine Entriegelungsposition verschiebbar, in der die Rastelemente der Verriegelungskulisse die Nuten der Zentrierstifte freigeben. Die Rastelemente der Verriegelungskulisse weisen jeweils eine angeschrägte erste Kontaktfläche für den konischen Kopf eines Zentrierstifts auf, durch welche die Verriegelungskulisse bei Einführen eines Zentrierstifts in die Entriegelungsposition verschiebbar ist. Des weiteren weist die Verriegelungskulisse angeschrägte zweite Kontaktflächen jeweils für einen konischen Kopf eines Zentrierstifts auf, durch welche die Zentrierstifte bei einer Verschiebung der Verriegelungskulisse von der Verriegelungsposition in die Entriegelungsposition aus der jeweiligen Aussparung an der Verriegelungskulisse herausdrückbar sind.

Die vorliegende Erfindung ermöglicht ein problemloses Hinzufügen bzw. Entfernen von Erweiterungsmodulen, ohne daß hierbei unzulässig hohe Zug- oder Scherkräfte auf Steckbindungselement zwischen Grundmodul und Erweiterungsmodul ausgeübt werden, die entweder ein Hinzufügen oder Entfernen von Erweiterungsmodulen insbesondere im laufenden Betrieb behindern oder elektrische Verbindungen schädigen.

Entsprechend einer vorteilhaften Ausgestaltung der vorliegenden Erfindung weist das Grundmodul ein weiteres Steckverbindungselement und eine weitere Verriegelungskulisse zur Aufnahme eines weiteren Erweiterungsmoduls auf. In entsprechender Weise kann auch das Erweiterungsmodul ein zusätzliches Steckverbindungselement und eine Verriegelungskulisse zur Aufnahme eines weiteren Erweiterungsmoduls aufweisen. In diesem Fall sind das zusätzliche Steckverbindungselement und die Verriegelungskulisse des Erweiterungsmoduls jeweils wie das Steckverbindungselement und die Verriegelungskulisse des Grundmoduls ausgestaltet. Dies ermöglicht eine besondere flexible Erweiterbarkeit des Grundmoduls um weitere Erweiterungsmodule.

Vorzugsweise ist die Verriegelungskulisse elastisch in der Verriegelungsposition vorgespannt, wodurch die Verriegelungskulisse nach Einführen eines Zentrierstifts aus der Entriegelungsposition in die Verriegelungsposition rückführbar ist. Die Verriegelungskulisse kann beispielsweise mittels einer Rückstellfeder elastisch in der Verriegelungsposition vorgespannt sein. Dies ermöglicht eine besonders einfache Handhabung zu ergänzender Erweiterungsmodule.

Entsprechend einer bevorzugten Ausgestaltung der vorliegenden Erfindung ist ein mit dem Grundmodul verbindbares Steckverbindungselement des zumindest einen Erweiterungsmoduls in Längsrichtung zwischen zwei Zentrierstiften angeordnet. Dies ermöglicht eine toleranzgerechte Führung mehrpoliger miteinander zu verbindender Steckverbindungselemente. Darüber hinaus kann die Verriegelungskulisse des Grundmoduls bzw. des zumindest einen Erweiterungsmoduls mittels eines Verriegelungsmechanismus in der Verriegelungsposition arretierbar sein. Auf diese Weise werden Steckverbindungselemente mechanisch noch weiter entlastet bzw. gegenüber einer unerwünschten Trennung gesichert.

Darüber hinaus kann das modulare Kommunikationsgerät beispielsweise als Switch ausgestaltet sein und eine Mehrzahl von Sende- und Empfangseinheiten umfassen, die jeweils einen Anschluß für eine Netzverbindung innerhalb eines industriellen Kommunikationsnetzes aufweisen. Die Sende- und Empfangseinheiten sind über ein Koppelelement schaltbar miteinander verbindbar. Das Koppelelement kann beispielsweise ein Hochgeschwindigkeitsbus oder ein Backplane Switch mit zugeordnetem Controller sein, wobei die Steckverbindungselemente an den Hochgeschwindigkeitsbus oder den Backplane Switch angekoppelt sind. Wahlweise können sowohl das Grundmodul als auch das zumindest eine Erweiterungsmodul oder beide Sende- und Empfangseinheiten umfassen. Dies ermöglicht eine äußerst flexible Erweiterbarkeit eines Switchs.

Die vorliegende Erfindung wird nachfolgend an einem Ausführungsbeispiel anhand der Zeichnung näher erläutert. Es zeigt
- Figur 1: ein Grundmodul eines modularen Kommunikationsgeräts mit mehreren andockbaren Erweiterungsmodulen,
- Figur 2: einen Schnitt durch zwei miteinander zu verbindende Erweiterungsmodule,
- Figur 3: eine Detaildarstellung eines Schnitts durch zwei miteinander verbundene Erweiterungsmodule in einem Bereich eines Zentrierstifts und einer Verriegelungskulisse,
- Figur 4: einen Schnitt durch die zwei Erweiterungsmodule gemäß Figur 2 in einer Entriegelungsposition.

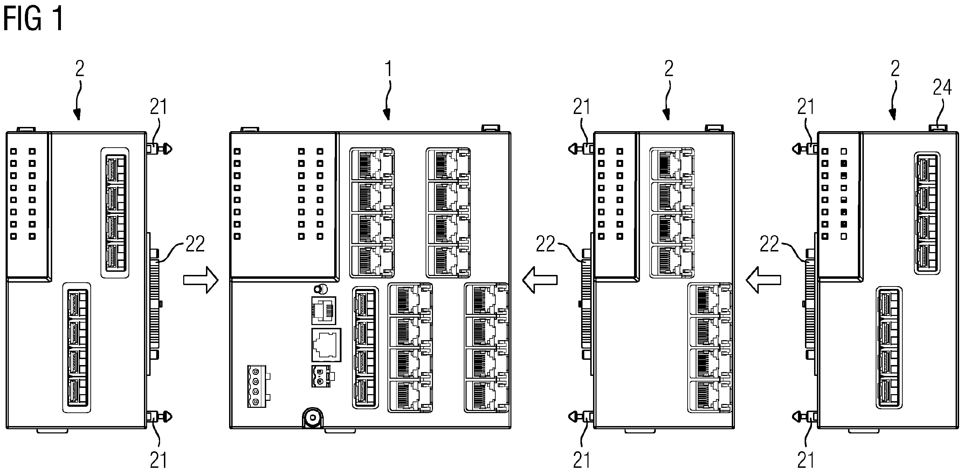

Das in Figur 1 dargestellte modulare Kommunikationsgerät für ein industrielles Automatisierungssystem umfaßt ein Grundmodul 1 und mehrere mit dem Grundmodul 1 verbindbare Erweiterungsmodule 2. Das Grundmodul 1 und die Erweiterungsmodule 2 weisen zueinander korrespondierende mehrpolige Steckverbindungselemente auf. Dabei sind die mit dem Grundmodul 1 verbindbaren, als Stecker ausgestalteten Steckverbindungselemente 22 der Erweiterungsmodule 2 jeweils in Längsrichtung zwischen zwei Zentrierstiften 21 angeordnet.

Im vorliegenden Ausführungsbeispiel ist das modulare Kommunikationsgerät als Switch ausgestaltet und umfaßt eine Mehrzahl von Sende- und Empfangseinheiten, die jeweils einen Anschluß für eine Netzverbindung innerhalb eines industriellen Kommunikationsnetzes aufweisen. Die Sende- und Empfangseinheiten sind über ein Koppelelement schaltbar miteinander verbindbar. Das Koppelelement kann ein Hochgeschwindigkeitsbus oder ein Backplane Switch mit zugeordnetem Controller sein, wobei die Steckverbindungselemente 22 an den Hochgeschwindigkeitsbus bzw. den Backplane Switch angekoppelt sind. Sowohl das Grundmodul 1 als auch die Erweiterungsmodule 2 umfassen entsprechend Figur 1 Sende- und Empfangseinheiten.

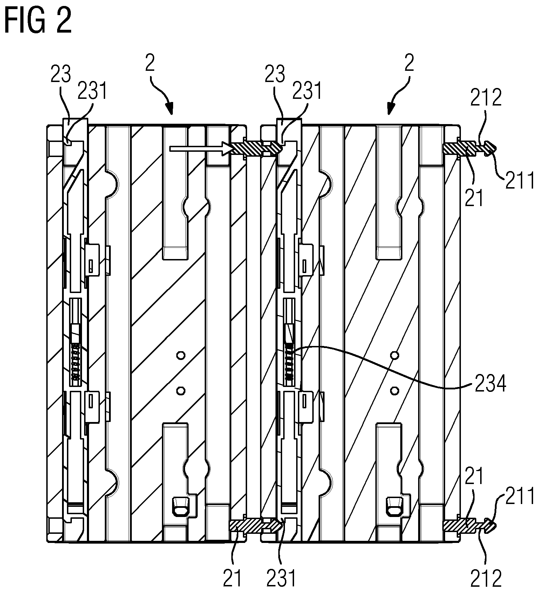

Das Grundmodul 1 umfaßt im vorliegenden Ausführungsbeispiel zwei als Buchsen ausgestaltete Steckverbindungselemente und zwei Verriegelungskulissen zur Aufnahme von jeweils einem Erweiterungsmodul. Die Erweiterungsmodule 2 umfassen entsprechend Figur 2 jeweils ebenfalls ein als Buchse ausgestaltetes Steckverbindungselement und eine Verriegelungskulisse 23 zur Aufnahme eines weiteren Erweiterungsmoduls 2. Dabei sind das als Buchse ausgestaltete Steckverbindungselement und die Verriegelungskulisse 23 eines Erweiterungsmoduls 2 jeweils wie die Steckverbindungselemente und die Verriegelungskulisse des Grundmoduls 1 ausgestaltet.

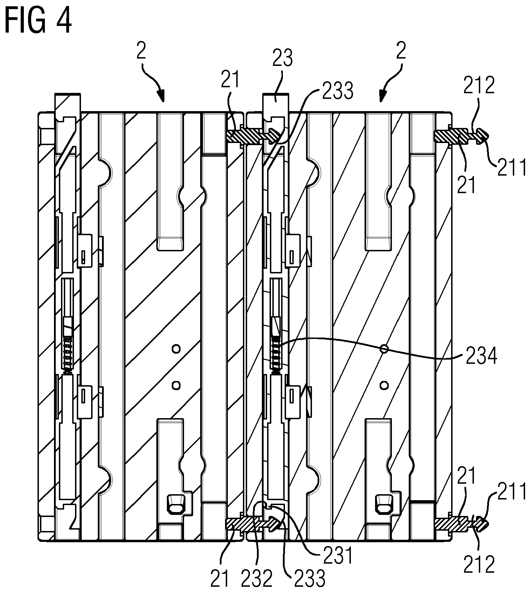

Die an den Erweiterungsmodulen 2 vorgesehenen Zentrierstifte 21 sind jeweils in eine Aussparung an einer Verrieglungskulisse 23 eines weiteren Erweiterungsmoduls 2 oder des Grundmoduls einführbar und dort verrastbar. Die Zentrierstifte weisen jeweils eine sich an einen konischen Kopf 211 anschließende umlaufende Nut 212 auf, in die jeweils ein Rastelement 231 der Verriegelungskulisse 23 in einem verriegelten Zustand eingreift. Die Verriegelungskulisse 23 ist senkrecht zu den Zentrierstiften 21 von einer Verriegelungsposition in eine Entriegelungsposition verschiebbar, in der die Rastelemente 231 der Verriegelungskulisse 23 die Nuten 212 der Zentrierstifte 21 entsprechend Figur 4 freigeben.

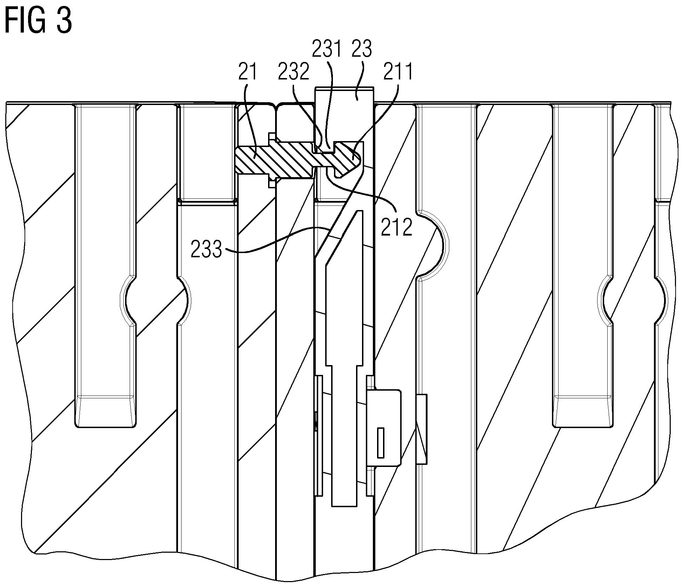

Anhand von Figur 3 ist im Detail zu erkennen, daß die Rastelemente 231 der Verriegelungskulisse 23 jeweils eine angeschrägte erste Kontaktfläche 232 für den konischen Kopf eines Zentrierstifts aufweisen, durch welche die Verriegelungskulisse 23 bei Einführen eines Zentrierstifts 21 in die Entriegelungsposition verschiebbar ist. Des weiteren weist die Verriegelungskulisse 23 angeschrägte zweite Kontaktflächen 233 jeweils für einen konischen Kopf 211 eines Zentrierstifts auf, durch welche die Zentrierstifte 21 bei einer Verschiebung der Verriegelungskulisse 23 von der Verriegelungsposition in die Entriegelungsposition aus der jeweiligen Aussparung an der Verriegelungskulisse 23 herausdrückbar sind. Entsprechend Figur 2 und 4 ist die Verriegelungskulisse 23 mittels einer Rückstellfeder 234 elastisch in der Verriegelungsposition vorgespannt ist. Dadurch ist die Verriegelungskulisse 23 nach Einführen eines Zentrierstifts 21 aus der Entriegelungsposition in die Verriegelungsposition rückführbar. Zusätzlich sind die Verriegelungskulissen des Grundmoduls bzw. der Erweiterungsmodule mittels eines in Figur 1 dargestellten Verriegelungsmechanismus 24 in der Verriegelungsposition arretierbar.

Durch Verwendung der Zentrierstifte 21, die in dafür ausgelegte Aufnahmen an den Verriegelungskulissen 23 eingeführt werden, läßt sich eine Vorzentrierung realisieren. Durch die Vorzentrierung ist sichergestellt, daß korrespondierende mehrpolige Steckverbindungselemente innerhalb mechanisch zulässiger Toleranzen miteinander verbunden werden. Die Zentrierstifte 21 halten durch Formschluß mit den Rastelelementen 231 der Verriegelungskulissen 23 mechanische Belastungen auf die korrespondierenden Steckverbindungselemente im wesentlichen ab. Mechanische Belastungen in Fügerichtung werden durch formschlüssige Verriegelung der Zentrierstifte 21 mit der jeweiligen Verriegelungskulisse 23 aufgenommen. Hierdurch ist beim Fügen sichergestellt, dass sich korrespondierende Steckverbindungselemente gewünscht treffen und somit eine Erweiterung des Grundmoduls 1 oder der Erweiterungsmodule 2 um weitere Erweiterungsmodule 2 im laufenden Betrieb ermöglichen.

## Patentansprüche

1. Modulares Kommunikationsgerät für ein industrielles Automatisierungssystem mit
- einem Grundmodul und zumindest einem mit dem Grundmodul (1) verbindbaren Erweiterungsmodul (2), wobei
- das Grundmodul und das zumindest eine Erweiterungsmodul zueinander korrespondierende mehrpolige Steckverbindungselemente (22) aufweisen,
- am Erweiterungsmodul Zentrierstifte (21) vorgesehen sind, die jeweils in eine Aussparung an einer Verrieglungskulisse (23) des Grundmoduls einführbar und dort verrastbar sind,
- die Zentrierstifte jeweils eine sich an einen konischen Kopf (211) anschließende umlaufende Nut (212) aufweisen, in die jeweils ein Rastelement (231) der Verriegelungskulisse in einem verriegelten Zustand eingreift,
- die Verriegelungskulisse senkrecht zu den Zentrierstiften von einer Verriegelungsposition in eine Entriegelungsposition verschiebbar ist, in der die Rastelemente der Verriegelungskulisse die Nuten der Zentrierstifte freigeben, wobei die Verriegelungskulisse elastisch in der Verriegelungsposition vorgespannt ist, wodurch die Verriegelungskulisse nach Einführen eines Zentrierstifts aus der Entriegelungsposition in die Verriegelungsposition rückführbar ist,
**dadurch gekennzeichnet, dass**
- die Rastelemente der Verriegelungskulisse jeweils eine angeschrägte erste Kontaktfläche (232) für den konischen Kopf eines Zentrierstifts aufweisen, die bei Einführen eines Zentrierstifts durch Kontakt mit dem konischen Kopf des Zentrierstifts ein Verschieben der Verriegelungskulisse in die Entriegelungsposition bewirkt,
- die Verriegelungskulisse angeschrägte zweite Kontaktflächen (233) jeweils für einen konischen Kopf eines Zentrierstifts aufweist, die bei einer Verschiebung der Verriegelungskulisse von der Verriegelungsposition in die Entriegelungsposition durch Kontakt mit dem konischen Kopf des jeweiligen Zentrierstifts ein Herausdrücken der Zentrierstifte aus der jeweiligen Aussparung an der Verriegelungskulisse bewirken.

2. Modulares Kommunikationsgerät nach Anspruch 1,
bei dem das Grundmodul ein weiteres Steckverbindungselement und eine weitere Verriegelungskulisse zur Aufnahme eines weiteren Erweiterungsmoduls aufweist.

3. Modulares Kommunikationsgerät nach einem der Ansprüche 1 oder 2,
bei dem das Erweiterungsmodul ein zusätzliches Steckverbindungselement und eine Verriegelungskulisse zur Aufnahme eines weiteren Erweiterungsmoduls aufweist, wobei das zusätzliche Steckverbindungselement und die Verriegelungskulisse des Erweiterungsmoduls jeweils wie das Steckverbindungselement und die Verriegelungskulisse des Grundmoduls ausgestaltet sind.

4. Modulares Kommunikationsgerät nach einem der Ansprüche 1 bis 3,
bei dem die Verriegelungskulisse mittels einer Rückstellfeder elastisch in der Verriegelungsposition vorgespannt ist.

5. Modulares Kommunikationsgerät nach einem der Ansprüche 1 bis 4,
bei dem ein mit dem Grundmodul verbindbares Steckverbindungselement des zumindest einen Erweiterungsmoduls in Längsrichtung zwischen zwei Zentrierstiften angeordnet ist.

6. Modulares Kommunikationsgerät nach einem der Ansprüche 1 bis 5,
bei dem die Verriegelungskulisse des Grundmoduls und/oder des zumindest einen Erweiterungsmoduls mittels eines Verriegelungsmechanismus in der Verriegelungsposition arretierbar sind/ist.

7. Modulares Kommunikationsgerät nach einem der Ansprüche 1 bis 6,
bei dem eine Mehrzahl von Sende- und Empfangseinheiten vorgesehen ist, und bei dem die Sende- und Empfangseinheiten jeweils einen Anschluß für eine Netzverbindung innerhalb eines industriellen Kommunikationsnetzes aufweisen, und bei dem die Sende- und Empfangseinheiten über ein Koppelelement schaltbar miteinander verbindbar sind.

8. Modulares Kommunikationsgerät nach Anspruch 7,
bei dem das Koppelelement ein Backplane Switch mit zugeordnetem Controller ist, und bei dem die Steckverbindungselemente an den Backplane Switch angekoppelt sind.

9. Modulares Kommunikationsgerät nach einem der Ansprüche 7 oder 8,
bei dem das Grundmodul und/oder das zumindest eine Erweiterungsmodul Sende- und Empfangseinheiten umfasst.

## Claims

1. Modular communication device for an industrial automation system comprising
- a basic module and at least one expansion module (2) that can be connected to the basic module (1), wherein
- the basic module and the at least one expansion module have multi-pole plug connecting elements (22) that correspond to one another,
- centring pins (21) are provided on the expansion module, said centring pins each being able to be inserted into a recess on a slotted locking guide (23) of the basic module and being able to be latched there,
- the centring pins each have a circumferential groove (212) attached to a conical head (211), into which groove in each case a latching element (231) of the slotted locking guide engages in a locked state,
- the slotted locking guide can be moved perpendicularly to the centring pins from a locking position into an unlocking position, in which the latching elements of the slotted locking guide release the grooves of the centring pins, wherein the slotted locking guide is elastically prestressed in the locking position, as a result of which the slotted locking guide can return from the unlocking position back into the locking position after insertion of a centring pin,
**characterized in that**
- the latching elements of the slotted locking guide each have a tapered first contact surface (232) for the conical head of a centring pin, said first contact surface, when a centring pin is inserted through contact with the conical head of the centring pin, causing the slotted locking guide to move into the unlocking position,
- the slotted locking guide has tapered second contact surfaces (233) in each case for a conical head of a centring pin, said second contact surface, when the slotted locking guide moves from the locking position into the unlocking position through contact with the conical head of the respective centring pin, causing the centring pin to be pushed out of the respective recess on the slotted locking guide.

2. Modular communication device according to Claim 1, in which the basic module has a further plug connecting element and a further slotted locking guide for receiving a further expansion module.

3. Modular communication device according to either of Claims 1 and 2, in which the expansion module has an additional plug connecting element and a slotted locking guide for receiving a further expansion module, wherein the additional plug connecting element and the slotted locking guide of the expansion module are each configured like the plug connecting element and the slotted locking guide of the basic module.

4. Modular communication device according to one of Claims 1 to 3, in which the slotted locking guide is elastically prestressed in the locking position by means of a restoring spring.

5. Modular communication device according to one of Claims 1 to 4, in which a plug connecting element of the at least one expansion module, said plug connecting element being able to be connected to the basic module, is arranged in the longitudinal direction between two centring pins.

6. Modular communication device according to one of Claims 1 to 5, in which the slotted locking guide of the basic module and/or of the at least one expansion module can be fixed in the locking position by means of a locking mechanism.

7. Modular communication device according to one of Claims 1 to 6, in which a plurality of transmission and reception units are provided, and in which the transmission and reception units each have a terminal for a network connection within an industrial communication network, and in which the transmission and reception units can be connected to one another in a switchable manner by way of a coupling element.

8. Modular communication device according to Claim 7, in which the coupling element is a backplane switch having an associated controller, and in which the plug connecting elements are coupled onto the backplane switch.

9. Modular communication device according to either of Claims 7 and 8, in which the basic module and/or the at least one expansion module comprises transmission and reception units.

## Revendications

1. Appareil de communication modulaire pour un système d'automatisation industrielle, comprenant
- un module de base et au moins un module (2) d'extension pouvant être relié au module (1) de base, dans lequel
- le module de base et le au moins un module d'extension ont des éléments (22) de liaison par enfichages multipolaires se correspondant les uns aux autres,
- il est prévu, sur le module d'extension, des chevilles (21) de centrage, qui peuvent être introduites respectivement dans un évidement d'une coulisse (23) de verrouillage du module de base et y être encliquetées,
- les chevilles de centrage ont respectivement une rainure (212), qui fait le tour, qui se raccorde à une tête (211) conique et dans laquelle pénètre, dans un état verrouillé, respectivement un élément (231) d'encliquetage de la coulisse de verrouillage,
- la coulisse de verrouillage peut coulisser perpendiculairement aux chevilles de centrage, d'une position de verrouillage à une position de déverrouillage, dans laquelle les éléments d'encliquetage de la coulisse de verrouillage dégagent les rainures des chevilles de centrage, la coulisse de verrouillage étant précontrainte élastiquement dans la position de verrouillage, grâce à quoi la coulisse de verrouillage peut, après introduction d'une cheville de centrage, être ramenée de la position de déverrouillage à la position de verrouillage,
**caractérisé en ce que**
- les éléments d'encliquetage de la coulisse de verrouillage ont chacun une première surface (232) de contact biseautée pour la tête conique d'une cheville de centrage, surface qui, lors de l'introduction d'une cheville de centrage, provoque, par contact avec la tête conique de la cheville de centrage, un coulissement de la coulisse de verrouillage dans la position de déverrouillage,
- la coulisse de verrouillage a des deuxièmes surfaces (233) de contact biseautées, respectivement pour une tête conique d'une cheville de centrage, surfaces qui, lors d'un coulissement de la coulisse de verrouillage, de la position de verrouillage à la position de déverrouillage, provoquent, par contact avec la tête conique de la cheville de centrage respective, une sortie des chevilles de centrage de l'évidement respectif de la coulisse de verrouillage.

2. Appareil de communication modulaire suivant la revendication 1,
dans lequel le module de base a un autre élément de liaison par enfichage et une autre coulisse de verrouillage pour la réception d'un autre module d'extension.

3. Appareil de communication modulaire suivant la revendication 1 ou 2,
dans lequel le module d'extension a un élément supplémentaire de liaison par enfichage et une coulisse de verrouillage pour la réception d'un autre module d'extension, l'élément supplémentaire de liaison par enfichage et la coulisse de verrouillage du module d'extension étant constitués respectivement, comme l'élément de liaison par enfichage et la coulisse de verrouillage du module de base.

4. Appareil de communication modulaire suivant l'une des revendications 1 à 3,
dans lequel la coulisse de verrouillage est précontrainte élastiquement dans la position de verrouillage au moyen d'un ressort de rappel.

5. Appareil de communication modulaire suivant l'une des revendications 1 à 4,
dans lequel un élément de liaison par enfichage, pouvant être relié au module de base, du au moins un module d'extension, est disposé dans la direction longitudinale entre deux chevilles de centrage.

6. Appareil de communication modulaire suivant l'une des revendications 1 à 5,
dans lequel la coulisse de verrouillage du module de base et/ou du au moins un module d'extension sont/est bloquée(s) dans la position de verrouillage au moyen d'un mécanisme de verrouillage.

7. Appareil de communication modulaire suivant l'une des revendications 1 à 6,
dans lequel il est prévu une pluralité d'unités d'émission et de réception et dans lequel les unités d'émission et de réception ont respectivement un accès pour une liaison à un réseau au sein d'un réseau de communication industriel et dans lequel les unités d'émission et de réception peuvent être reliées les unes aux autres de manière commutable par un élément de couplage.

8. Appareil de communication modulaire suivant la revendication 7, dans lequel l'élément de couplage est un backplane switch à unités de commande associées et dans lequel les éléments de liaison par enfichage sont couplés au backplane switch.

9. Appareil de communication modulaire suivant l'une des revendications 7 ou 8,
dans lequel le module de base et/ou le au moins un module d'extension comprend des unités d'émission et de réception.
